# EUROPÄISCHE PATENTSCHRIFT

(11) **EP 1 555 699 B1**
(45) Veröffentlichungstag und Bekanntmachung des Hinweises auf die Patenterteilung: **07.11.2007**
(21) Anmeldenummer: 04106604.4
(22) Anmeldetag: 15.12.2004
(51) Int. Cl.: H01L 41/053

(54) **Abdeckung für ein Aktorgehäuse und Herstellungsverfahren für eine solche Abdeckung**
Cover for actuator casing and method of manufacturing such cover
Couvercle pour boîtier d'actionneur et procédé de fabrication d'un tel couvercle

(30) Priorität: 12.01.2004 DE 102004001677
(43) Veröffentlichungstag der Anmeldung: 20.07.2005
(73) Patentinhaber: SIEMENS AKTIENGESELLSCHAFT, 80333 München (DE)
(72) Erfinder: Unruh, Marcus, 93197 Zeitlarn (DE); Plechner, Klaus, 93197 Zeitlarn (DE)

(56) Entgegenhaltungen:
- WO-A-03/069152
- DE-A1- 19 818 068
- DE-A1- 19 940 346
- DE-C1- 19 844 743
- US-A- 5 113 108
- US-A- 5 243 492
- US-A- 5 477 102

## Beschreibung

Die Erfindung betrifft eine Abdeckung und ein Herstellungsverfahren für eine Abdeckung

In modernen Einspritzanlagen für Brennkraftmaschinen werden piezoelektrische Aktoren als Stellglieder für Einspritzventile eingesetzt. Die Aktoren werden entweder mit ihrem elektrischen Anschlussstecker vollständig im Zylinderkopf einer Brennkraftmaschine eingebaut oder sie werden außerhalb des Zylinderkopfs angeordnet. Bei beiden Varianten ist es notwendig, den Aktor in eine schützende Hülle einzubauen, um ihn vor schädigenden Einflüssen zu schützen. Dies geschieht durch Einbau des Aktors in ein Gehäuse, das den Aktor schützt. Problematisch hierbei ist beispielsweise die Durchführung der für eine elektrische Ansteuerung des Aktors notwendigen Anschlusskontakte durch das Gehäuse.

Aus der DE 199 40 346 A1 und der DE 199 40 347 A1 ist eine Anschlussvorrichtung für einen piezoelektrischen Aktor bekannt, die mit einer isolierenden Umspritzung aus Kunststoff versehen wird. Die Umspritzung mit Kunststoff weist jedoch verschiedene Nachteile auf. Um das Eindringen von Kunststoff in das Innere des Aktorgehäuses beim Umspritzen zu verhindern, muss auch zwischen dem Aktorgehäuse und der Anschlussvorrichtung eine Abdichtung vorliegen. Weiterhin ist die Umspritzung mit Kunststoff aufwendig. Außerdem ist auch die Abdichtwirkung des Kunststoffs an den Durchführungen für die Anschlusskontakte unzureichend, so dass das Innere des Aktors ungenügend gegen eindringendes Motoröl oder eindringendes Wasser geschützt ist. Es besteht auch die Gefahr, dass beispielsweise bei einer gebrochenen Dichtmembran innerhalb des Injektors Kraftstoff über den Aktor austreten kann.

Die Druckschrift WO 03/069152 A beschreibt ein Dichtungselement für einen Piezoaktor eines Kraftstoff-Einspritzventils. Dieses Dichtungselement ist auf die Kopfplatte eines Piezoaktors aufsteckbar, wobei der Piezoaktor zum Einbau in einen Injektorkörper eines Einspritzmotors vorgesehen ist. Das Dichtungselement ist aus einem Elastomer und an einem ersten Ende des Dichtungselements, mit dem das Dichtungselement in den Injektorkörper einsetzbar ist, ist mindestens ein umlaufender Dichtungswulst angeformt, welcher eine Abdichtung zum Injektorkörper hin bewirkt. Weiter weist das Dichtungselement mindestens eine Durchführung zur Aufnahme eines Kontaktstiftes auf, der sich in Längsrichtung durch das Dichtungselement hindurch erstreckt, wobei die mindestens eine Durchführung mittels zweiter Dichtmittel zu dem Kontaktstift hin abgedichtet ist, wobei die Dichtwirkungen des mindestens einen umlaufenden Dichtungswulst einerseits und der zweiten Dichtmittel andererseits voneinander entkoppelt sind.

Des Weiteren zeigt die Druckschrift US 5,113,108 A einen hermetisch abgedichteten elektrostriktiven Aktor.

Der Erfindung liegt daher die Aufgabe zugrunde, eine Abdeckung für ein Aktorgehäuse anzugeben, die mit möglichst geringem Aufwand das Innere des Aktors möglichst zuverlässig abdichtet. Es ist weiterhin Aufgabe der Erfindung, ein Herstellungsverfahren anzugeben, mit dem eine solche Abdeckung mit möglichst geringem Aufwand hergestellt werden kann.

Die Aufgabe wird mit einer Abdeckung gemäß Anspruch 1 gelöst. Weiterhin ist ein Herstellungsverfahren gemäß Anspruch 17 geeignet, eine solche Abdeckung herzustellen.

Die Erfindung geht von der technischen Erkenntnis aus, dass zur Abdichtung des Aktorgehäuses an dessen Außenseite ein Deckel verwendet werden kann, der als vorgeformtes Formteil hergestellt wird. Dabei kann der Deckel als Scheibe ausgestaltet sein, die eine Nut am Rand aufweisen kann, oder als Scheibe mit einem umlaufenden heruntergezogenen Rand, so dass der Rand den Aktor teilweise umfasst.

Wird der Deckel als vorgeformtes Formteil hergestellt, so bietet dies den Vorteil, dass in dem Deckel eine Durchführung für einen Außenkontakt, der eine elektrische Ansteuerung des Aktors ermöglicht, angeordnet werden kann. Diese Durchführung kann mit einer Dichtung zur Abdichtung der Durchführung versehen werden, bevor der Deckel an dem Aktorgehäuse angebracht wird. Dabei können Abdichtungen verwendet werden, die für ihre Herstellung besondere Herstellbedingungen wie beispielsweise eine erhöhte Temperatur benötigen. Die Herstellung des

Deckels oder der Abdichtung ist damit unabhängig von eventuell im Zusammenhang mit dem Aktor zu berücksichtigenden Temperaturgrenzwerten. Solche Temperaturgrenzwerte können beispielsweise durch eine Silikonmasse, in welche die Piezoelemente des Piezoaktors eingegossen sind, oder die Curie-Temperatur der Piezokeramik vorgegeben sein. Durch die Ausführung des Deckels als vorgeformtes Formteil ist es auch möglich, das Deckelmaterial auf seine Eignung für den Einbau der Dichtung und auf seine Widerstandsfähigkeit gegen schädigende Umgebungseinflüsse zu optimieren. Weiterhin ist zur Montage eines vorgeformten Formteils auf dem Aktorgehäuse kein aufwendiger Spritzgussprozess notwendig. Der Deckel kann beispielsweise angeschraubt oder angeschweißt werden.

Vorzugsweise besteht der Deckel mindestens teilweise aus Metall oder Keramik. Diese Werkstoffe bieten den Vorteil einer hohen Temperaturwiderstandsfähigkeit und einer hohen Widerstandsfähigkeit gegen Umwelteinflüsse wie beispielsweise Motoröl oder Feuchtigkeit. Weiterhin bieten sie den Vorteil einer hohen Festigkeit.

Die Dichtung zur Abdichtung der Durchführung der Außenkontakte kann eine Glasdichtung sein, die zwischen dem Außenkontakt und dem Deckel angeordnet ist. Eine Glasdichtung bietet den Vorteil einer sehr guten Abdichtung, wobei die Glasdichtung vorzugsweise eine Grenzleckrate von 10⁻⁸ mbar/s aufweist. Eine kleine Grenzleckrate ist vorteilhaft, da sie ein Eindringen von Flüssigkeiten oder Gasen in den Aktorraum verhindert. So können auch Glasdichtungen mit einer Grenzleckrate von 10⁻¹¹ mbar/s oder weniger sinnvoll sein. Wird der Außenkontakt vollständig von der Glasdichtung umschlossen, so bietet dies den Vorteil, dass die Glasdichtung gleichzeitig den Außenkontakt gegenüber dem Deckel elektrisch isoliert, was besonders dann von Vorteil ist, wenn der Deckel aus Metall besteht. Es kann jedoch auch aufgrund der Konstruktion der Glasdichtung oder des Deckels vorteilhaft sein, dass die Glasdichtung den durchgeführten Außenkontakt nur teilweise umschließt.

Die Glasdichtung kann als angepasste Glas-Metall-Durchführung oder als Druckglasdurchführung ausgeführt sein. Bei angepassten Glas-Metall-Durchführungen werden Gläser und Metallteile verwendet, deren Ausdehnungskoeffizienten zwischen Raumtemperatur und der Transformationstemperatur des Glases weitgehend übereinstimmen. Damit wird erreicht, dass der durchgeführte Außenkontakt in das Glas eingeschmolzen wird und beim Abkühlen keine mechanischen Spannungen in der Verschmelzung entstehen. Angepasste Glasmetalldurchführungen bieten beispielsweise den Vorteil, dass in eine Durchführung ohne großen Aufwand mehrere Außenkontakte eingeschmolzen werden können, die durch das Glas voneinander elektrisch isoliert sind. Dagegen werden bei Druckglasdurchführungen Metalle und Gläser eingesetzt, deren Wärmeausdehnungskoeffizienten unterschiedlich sind. Vorzugsweise ist der Wärmeausdehnungskoeffizient des außenliegenden Deckels höher als der des Einschmelzglases und der des metallischen Außenkontaktes. Dies bietet den Vorteil, dass nach dem Einsetzen der Glasdichtung und des metallischen Außenkontaktes und der nachfolgenden Abkühlung der außenliegende Deckel infolge seiner wesentlich höheren Kontraktion das Glas zusammendrückt. Dies bietet den Vorteil, dass die Dichtung unter Druck steht und damit eine sehr geringe Leckrate aufweist. Beispielsweise kann der Deckel aus einem Metall bestehen, das zwischen 20 und 300°C einen Wärmeausdehnungskoeffizienten α von 13x10⁻⁶ 1/K aufweist. Es ist jedoch auch möglich, Ausdehnungkoeffizienten zwischen 9x10⁻⁶ 1/K und 18x10⁻⁶ 1/K zu verwenden. Der Ausdehnungskoeffizient in demselben Temperaturbereich des Glases und des Außenkontaktes sollte darunter liegen, beispielsweise zwischen 5x10⁻⁶ 1/K und 9x10⁻⁶ 1/K.

Vorzugsweise weist die Abdeckung eine an dem Aktorgehäuse befestigbare Kopfplatte auf. Die Kopfplatte hat den Vorteil, dass sie als Träger für eine Rohrfeder des Aktors dienen kann, wobei die Rohrfeder die Piezoelemente des Aktors gegenüber der Kopfplatte vorspannen kann. Eine solche Vorspannung ist vorteilhaft, da dadurch eine Selbstzerstörung der Piezoelemente verhindert wird. Vorzugsweise werden in der Kopfplatte Kopfplattendurchführungen angeordnet, um einen vom dem Aktor kommenden Aktorkontakt zur elektrischen Ansteuerung des Aktors durch die Kopfplatte hindurchzuführen. Dies bietet den Vorteil, dass der Aktorkontakt außerhalb der Kopfplatte an den Außenkontakt zur Kontaktierung des Aktors angeschlossen werden kann. Vorzugsweise wird der Deckel mit der Kopfplatte verbunden, um den Deckel zu fixieren. Wird die Kopfplatte abdichtend am Aktorgehäuse und der Deckel abdichtend an der Kopfplatte befestigt, so bietet dies den Vorteil, dass der Aktor abgedichtet ist. Vorzugsweise weist der Deckel einen heruntergezogenen Rand oder die Kopfplatte einen heraufgezogenen Rand auf, an dem der Deckel befestigt wird, so dass zwischen der Kopfplatte und dem Deckel ein Hohlraum entsteht. Dieser Hohlraum bietet den Vorteil, dass innerhalb des Hohlraums Bauteile, die beispielsweise zur Kontaktierung oder zum Betrieb des Aktors nötig sind, geschützt vor schädigenden Umwelteinflüssen angeordnet werden können.

Vorzugsweise besteht die Kopfplatte mindestens teilweise aus Metall oder Keramik. Metall oder Keramik bieten den Vorteil einer hohen Festigkeit und einer hohen Widerstandsfähigkeit gegen Angriffe schädlicher Umgebungseinflüsse.

Der Deckel wird vorteilhafterweise mit der Kopfplatte verschweißt, wobei der Deckel und die Kopfplatte in diesem Fall aus Metall bestehen. Eine Schweißverbindung bietet den Vorteil, dass sie eine dauerhafte Verbindung darstellt, die, falls sie umlaufend ausgeführt wird, eine sichere Abdichtung zwischen dem Deckel und der Kopfplatte darstellen kann. Weiterhin kann auch die Kopfplatte mit dem Gehäuse des Aktors verschweißt sein, wodurch auch auf einfache Weise eine widerstandsfähige und umfassende Abdichtung erreicht werden kann.

Vorzugsweise wird auch die Rohrfeder zur Aufbringung der Vorspannung mit der Kopfplatte verschweißt. Dies bietet den Vorteil einer mechanisch widerstandsfähigen und dauerhaften Verbindung zwischen der Kopfplatte und der Rohrfeder, wodurch eine Vorspannung der Piezoelemente des Aktors möglich ist.

Auf der Innseite des Deckels ist ein Mittelteil angeordnet, das eine Kontaktbrücke aufweist. Wird das Mittelteil auf der Innenseite des Deckels angeordnet, beispielsweise zwischen der Kopfplatte und dem Deckel, so liegt es innerhalb des vor Umgebungseinflüssen geschützten Bereichs. Die Kontaktbrücke bietet den Vorteil, dass der vom Aktor kommende Aktorkontakt mit dem von außen zugänglichen Außenkontakt über die Kontaktbrücke kontaktiert werden kann und damit eine elektrische Ansteuerung des Aktors von außen möglich ist. Die Kontaktbrücke kann mit dem Aktorkontakt beispielsweise vor Aufsetzen des Deckels verschweißt werden. Es ist jedoch auch möglich, die Kontaktbrücke mit einem Steckkontakt für den Aktorkontakt auszurüsten, was die Montage erleichtern würde. Eine Schweißverbindung hat dagegen den Vorteil, dass sie eine zuverlässige Fixierung der Kontaktbrücke ermöglicht.

Vorzugsweise weist die Kontaktbrücke eine Steckverbindung auf, um die Kontaktbrücke mit dem Außenkontakt steckbar elektrisch zu kontaktieren. Dies hat den Vorteil, dass der als Formteil vorgefertigte Deckel einfach aufgesetzt wird, wobei die bereits im Deckel montierten Außenkontakte in die Steckverbindungen eingesteckt werden. Damit wird eine elektrische Kontaktierung der Kontaktbrücke mit dem Außenkontakt erreicht. Dies ist deswegen von Vorteil, da nach Aufsetzen des Deckels die Kontaktbrücke von außen nicht mehr zugänglich ist, falls der Deckel in dieser Lage mit dem Aktorgehäuse oder der Kopfplatte bündig abschließt. Nach Aufsetzen des Deckels und Einstecken der Außenkontakte in die Kontaktverbindungen muss der Deckel nur noch abdichtend mit der Kopfplatte oder dem Gehäuse des Aktors verbunden werden, beispielsweise durch eine Schweißverbindung, um den Aktor nach außen abzudichten.

Vorzugsweise werden mehrere Außenkontakte in dem Deckel angeordnet, so dass mehrere Aktorkontakte über die Kontaktbrücke mit mehreren Außenkontakten elektrisch kontaktierbar sind. Dies hat beispielsweise bei einem piezoelektrischen Aktor, der zwei Aktorkontakte aufweist, den Vorteil, dass alle Aktorkontakte von außen elektrisch ansteuerbar sind, falls mindestens zwei Außenkontakte in dem Deckel angeordnet werden. Es können jedoch auch mehr als zwei Außenkontakte angeordnet werden, beispielsweise um auch ein oder mehrere Thermoelemente, die eine Temperatur des Aktors aufnehmen, nach außen zu kontaktieren. Werden mehrere Außenkontakte in dem Deckel angeordnet, so ist es von Vorteil, falls die Außenkontakte farblich oder gestalterisch gekennzeichnet werden, um sie den einzelnen Aktorkontakten nach der Montage des Deckels zuordnen zu können. Beispielsweise können zur Abdichtung der Außenkontakte verwendete Glasdichtungen in unterschiedlichen Farben ausgeführt werden, um die Außenkontakte zu kennzeichnen. So können beispielsweise zwei Aktorkontakte mit den Farben rot und blau und zwei weitere Kontakte eines Thermoelements mit den Farben grün und gelb gekennzeichnet sein.

Vorteilhafterweise kann innerhalb des Deckels ein elektrisches Bauelement angeordnet sein, das mit mindestens einem der Aktorkontakte elektrisch kontaktiert ist. Dies hat den Vorteil, dass das elektrische Bauelement im geschützten und abgedichteten Bereich innerhalb des Deckels liegt. Beispielsweise kann das elektrische Bauelement in einem Freiraum zwischen dem Deckel und der Kopfplatte angeordnet werden. Das elektrische Kontaktieren des elektrischen Bauelements mit mindestens einem der Aktorkontakte kann vorteilhaft sein, falls für den Betrieb des Aktors ein mit den Aktorkontakten verbundenes elektrisches Bauelement nötig ist. So kann es beispielsweise vorteilhaft sein, die beiden Aktorkontakte eines Piezoaktors mit einem Widerstand zu verbinden, um Ladungszustände des Piezoaktors aufgrund thermischer Änderungen und äußerer Krafteinwirkungen im unbetriebenen Zustand abzubauen. In einem solchen Fall wird das Bauelement vorzugsweise am Mittelteil angeordnet und mit der Kontaktbrücke elektrisch kontaktiert. Dies hat den Vorteil, dass das elektrische Bauelement der Kontaktbrücke in kompakter Bauform innerhalb des Deckels angeordnet ist.

Das Mittelteil besteht vorzugsweise teilweise aus einem elektrisch isolierenden Material, wobei die Kontaktbrücke oder das elektrische Bauelement zumindest teilweise in das elektrisch isolierende Material eingebettet sind. Dies hat den Vorteil, dass die Kontaktbrücke oder das elektrische Bauelement gegenüber ihrer Umgebung elektrisch isoliert sind. So kann beispielsweise bei einer Kopfplatte oder einem Deckel aus Metall ein unbeabsichtigter Rückschluss verhindert werden. Aus dem elektrisch isolierenden Material des Mittelteils lässt sich vorteilhafterweise auch eine Führung für die Steckverbindungen der Außenkontakte bilden. Auch ist es möglich, das Mittelteil als Formteil auszuführen, so dass es ohne weitere Befestigungseinrichtungen passgenau in beispielsweise das Kopfteil hineinpasst. Das elektrisch isolierende Material kann beispielsweise Kunststoff sein, wobei auch vorstellbar ist, Keramik zu verwenden. Kunststoff hat den Vorteil, dass im Spritzgussverfahren unter geringem Aufwand ein Formteil hergestellt werden kann, in das die Kontaktbrücke oder das elektrische Bauelement eingebettet sein können. Keramik hat den Vorteil einer höheren Temperaturbeständigkeit.

Das Mittelteil weist vorzugsweise eine hervorstehende Hülse aus dem elektrisch isolierenden Material auf, wobei die Hülse in die Kopfplattendurchführung hineingreift und der Aktorkontakt in der Hülse durch die Kopfplatte hindurchgeführt ist. Auf diese Weise lässt sich eine elektrische Isolierung zwischen dem Aktorkontakt und der Kopfplatte herstellen. Dies hat den Vorteil, dass es über die Kopfplatte nicht zu einem Kurzschluss des Aktorkontakts kommt. Weiterhin wird dadurch das Mittelteil in seiner Lage auf der Kopfplatte innerhalb des Deckels besser fixiert. Weist die Hülse einen Außendurchmesser auf, der im Wesentlichen gleich dem Durchmesser der Kopfplattendurchführung ist, so hat dies den Vorteil, dass die Hülse die Kopfplattendurchführung vollständig ausfüllt, wodurch das Mittelteil besser fixiert wird. Damit kann auch eine zusätzliche Abdichtung des Innenraums des Aktors erfolgen. Sollte die Dichtung des Deckels versagen, so wäre noch eine weitere Sperre vorhanden, bevor Flüssigkeiten oder Gase von außen in den Innenraum eindringen könnten.

Weiterhin umfasst die Erfindung ein Herstellungsverfahren zur Herstellung der oben beschriebenen vorteilhaften Ausführungsform.

Zur Herstellung einer erfindungsgemäßen Abdeckung werden vorzugsweise in den Deckel die Durchführungen gebohrt, wobei der Deckel aus Metall besteht. Der mit den Durchführungen versehene Deckel wird erwärmt, beispielsweise auf etwa 300°C. In den erwärmten Deckel werden die erwähnten Glasdichtungen für die Druckglasdurchführung der Außenkontakte in den Deckel eingesetzt. Weiterhin werden die erwärmten Außenkontakte in den Deckel mit der Glasdichtung eingesetzt und nachfolgend der Deckel mit der Glasdichtung und den Außenkontakten abgekühlt, so dass der Außenkontakt und die Glasdichtung verspannt in dem Deckel verbleiben. Auf diese Weise kann ohne großen Aufwand eine Druckglasdurchführung in dem Deckel hergestellt werden. Der Deckel wird vorzugsweise auf die Kopfplatte aufgesetzt, wobei der Außenkontakt in die Steckverbindung gesteckt wird und der Deckel an der Kopfplatte angeschweißt wird. Dadurch ist zum einen eine Kontaktierung des Außenkontakts mit dem Aktorkontakt, der an der Kontaktbrücke angeschweißt sein kann, gewährleistet und weiterhin eine Abdichtung des Aktors, da sowohl die Schweißverbindung als auch die Drucklastdurchführung das Innere gegenüber schädigenden Umgebungseinflüssen abdichten.

Weiterhin umfasst die Erfindung einen Aktor mit einer Abdeckung in einer der oben beschriebenen vorteilhaften Ausführungsformen. Ein Injektor für eine Brennkraftmaschine, der einen Aktor mit einer Abdeckung in einer der oben beschriebenen vorteilhaften Ausführungsformen enthält, hat den Vorteil, dass auch bei schädigenden Umgebungseinflüssen ein zuverlässiger Betrieb möglich ist.

Weiterhin umfasst die Erfindung eine Einspritzanlage für eine Brennkraftmaschine mit einem oder mehreren der oben beschriebenen Aktoren.

Die erfindungsgemäße Abdeckung, die mit einem erfindungsgemäßen Herstellungsverfahren hergestellt werden kann, wird anschließend anhand der beigefügten Abbildungen näher erläutert.
- Figur 1: zeigt eine Explosionsdarstellung einer erfindungsgemäßen Abdeckung mit Teilen eines Aktors, an dem die Abdeckung montiert wird.
- Figuren 2A bis 2C: zeigen drei Schnittansichten der erfindungsgemäßen Abdeckung mit einem durch die Abdeckung abgedichteten Aktor.
- Figur 3: zeigt ein Detail der in den anderen Figuren dargestellten erfindungsgemäßen Abdeckung.

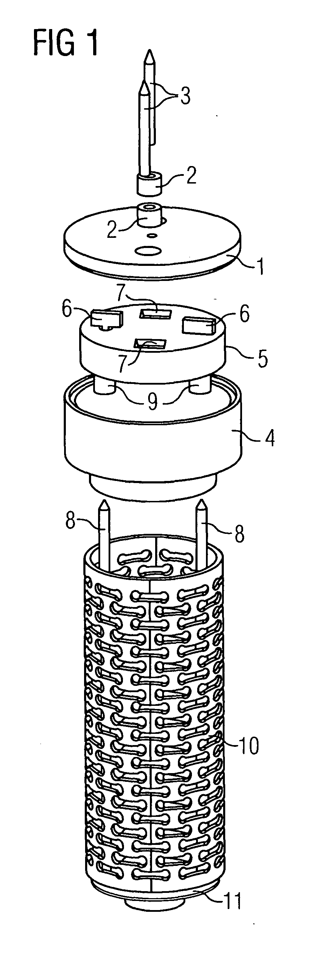

Figur 1 zeigt eine erfindungsgemäße Abdeckung und einige Teile eines durch die Abdeckung abgedeckten Piezoaktors in Explosionsdarstellung. In einem Deckel 1 sind in zwei Bohrungen zwei Glasdichtungen 2 angeordnet, in denen zwei Außenkontakte 3 hindurchgeführt sind. Der Deckel 1 ist auf einem umlaufend hochgezogenem Rand einer Kopfplatte 4 angeschweißt, die an einem in Figur 1 nicht dargestellten Aktorgehäuse angeschweißt wird. Beide Schweißnähte sind umlaufend ausgeführt, so dass eine abgedichtete Verbindung zwischen dem Deckel 1 und der Kopfplatte 4 und der Kopfplatte 4 und dem Aktorgehäuse vorhanden ist. In einem durch die Kopfplatte 4 und den Deckel 1 gebildeten Hohlraum wird ein Mittelteil 5 angeordnet, das eine Kontaktbrücke 6 mit zwei Steckverbindungen 7 aufweist. Das Mittelteil 5 wird hergestellt, indem die Kontaktbrücke 6 mit den zwei Steckverbindungen 7 mit Kunststoff im Spritzgussverfahren umspritzt wird, so dass nur zwei Anschlusslaschen der Kontaktbrücke 6 und die Steckverbindungen 7 zugänglich sind. In die Steckverbindungen 7 werden die Außenkontakte 3 eingesteckt. Zur elektrischen Kontaktierung des Aktors werden zwei Aktorkontakte 8 durch zwei Durchführungen der Kopfplatte 4, die hier nicht dargestellt sind, und durch zwei Hülsen 9 hindurchgeführt und mit der Kontaktbrücke 6 verschweißt sind. Die Hülsen 9 sind Teil des Mittelteils 5. An der Kopfplatte 4 ist eine Rohrfeder 10 angeschweißt, welche die Piezoelemente des Aktors unter Vorspannung setzt, wobei die Piezoelemente durch eine Abstützplatte 11 gehalten werden.

Im dargestellten Fall wird eine Druckglasdurchführung ausgeführt, bei der die Glasdichtungen 2 zusammen mit den Außenkontakten 3 bei einer Temperatur von etwa 300°C in den Deckel 1 eingesetzt werden und dann abgekühlt werden. Der Deckel 1 weist einen Temperaturkoeffizienten im Bereich zwischen 20°C und 300°C von 13 x 10⁻⁶ 1/K auf. Das Glas der Glasdichtungen 2 und das Metall der Außenkontakte 3 weisen im genannten Temperaturbereich einen Temperaturausdehnungskoeffizienten von 9 x 10⁻⁶ 1/K auf. Beim Abkühlen entstehen durch die stärkere Kontraktion des Deckels 1 in den Glasdichtungen 2 und in den Außenkontakten 3 Druckspannungen, wodurch eine formschlüssige Abdichtung erreicht wird. Der so vorgefertigte Deckel 1 wird auf die Kopfplatte 4 aufgesetzt, wobei die Außenkontakte 3 in die Steckverbindungen 7 eingesteckt werden. Anschließend wird der Deckel 1 mit der Kopfplatte 4 umlaufend verschweißt, um eine abgedichtete Befestigung des Deckels 1 an der Kopfplatte 4 zu erreichen. Dafür kann beispielsweise eine elektrische Widerstandsschweißung, eine Laserschweißung, ein Press-It-Verfahren oder ein Kaltschweißverfahren verwendet werden. Im vorliegenden Ausführungsbeispiel wird für alle Schweißverbindungen eine elektrische Widerstandsschweißung mit einer Phasenanschnitt-Schweißstromsteuerung verwendet, da dies eine sehr präzise Ausführung der Schweißnaht mit einfachen Mitteln ermöglicht.

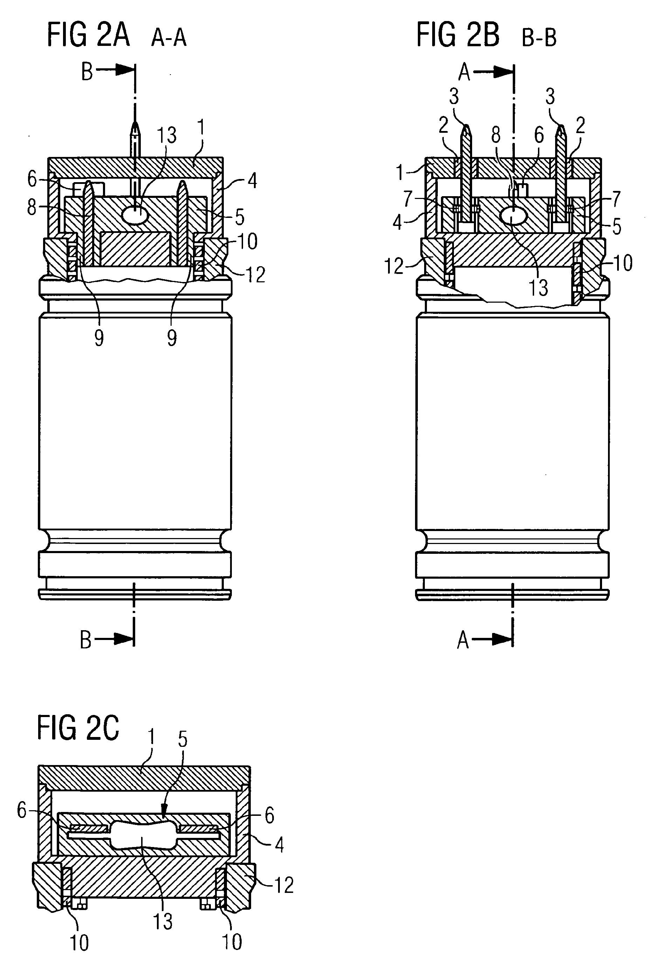

In den Figuren 2A bis 2C sind drei Schnittdarstellungen der in Figur 1 in Explosionsdarstellung gezeigten Abdeckung gezeigt. Die gleichen Bezugszeichen bezeichnen dieselben Bauteile und sind hier nicht noch einmal erläutert. In Figur 2A ist der Schnitt A-A dargestellt, der mittig durch den Aktor verläuft und die beiden Aktorkontakte 8 schneidet. in Figur 2B ist der Schnitt B-B dargestellt, der um 90° zum Schnitt A-A bezüglich der Längsachse des Aktors gedreht ist und den Aktor mittig und die Außenkontakte 3 schneidet. Die Längsachse des Aktors ist die Achse, in der sich der Aktor im Betrieb ausdehnt. Der in Figur 2C dargestellte Schnitt ist gegenüber dem Schnitt A-A und dem Schnitt B-B jeweils um 45° bezüglich der Längsachse des Aktors gedreht.

In Figur 2A ist neben den in Figur 1 dargestellten Bauteilen zusätzlich ein Aktorgehäuse 12 und ein elektrischer Widerstand 13 gezeigt. Das Aktorgehäuse 12 umschließt die Rohrfeder 10 und ist an der Kopfplatte 4 angeschweißt. Der Widerstand 13 ist zusammen mit der Kontaktbrücke 6 in Kunststoff eingegossen und verbindet über die Kontaktbrücke 6 die beiden Aktorkontakte 8.

In Figur 2B ist die Lage der Außenkontakte 3 in den Steckverbindungen 7 gezeigt. Über die Steckverbindungen 7 der Kontaktbrücke 6 sind die Aktorkontakte 8 mit den Außenkontakten 3 kontaktiert.

In der Figur 2C ist die Lage das Widerstands 13 und der Kontaktbrücke 6 in dem aus einer Kunststoffumspritzung bestehenden Mittelteil 5 gezeigt. Der Widerstand 13 ist an die Kontaktbrücke 6 mit seinen beiden Anschlusspins angeschweißt.

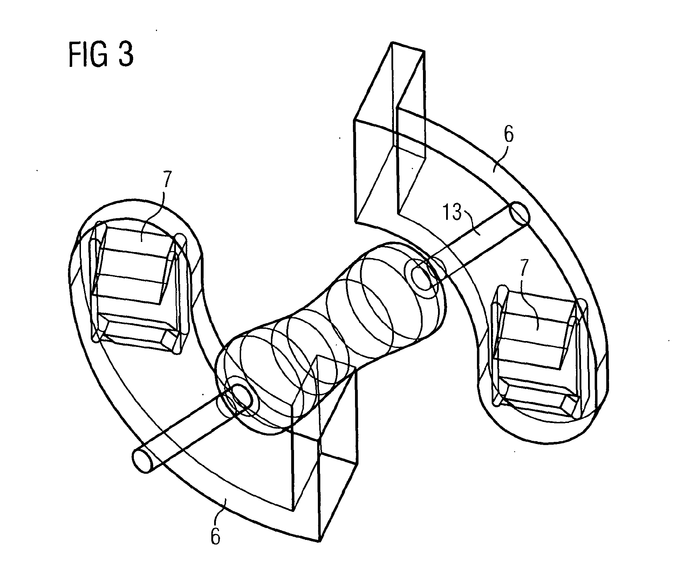

In Figur 3 ist die Kontaktbrücke 6 mit dem Widerstand 13 in einer durchsichtigen Darstellung gezeigt, bei der nur die Kanten gezeigt sind. Der Widerstand 13 ist an der Kontaktbrücke 6 angeschweißt. Die Kontaktbrücke 6 weist zwei Laschen auf, an welche die Aktorkontakte 8 angeschweißt werden. Weiterhin weist die Kontaktbrücke 6 zwei Steckverbindungen 7 auf, in welche die Außenkontakte 3 gesteckt werden. Die Kontaktbrücke 6 und der Widerstand 13 werden wie in den Figuren 1 und 2A bis 2C gezeigt in eine Kunststoffumspritzung eingefasst.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen.

## Patentansprüche

1. Abdeckung für ein Aktorgehäuse (12) eines Aktors, insbesondere eines Piezoaktors, mit
einem Deckel (1), der das Aktorgehäuse (12) an dessen Außenseite abdichtet, wobei der Deckel (1) ein vorgeformtes Formteil (1) ist,
einer in dem Deckel (1) angeordneten Durchführung,
einem durch die Durchführung hindurchgeführten Außenkontakt (3), der eine elektrische Ansteuerung des Aktors durch eine externe Steuereinheit ermöglicht, und
einer Dichtung (2) zur Abdichtung der Durchführung, die zwischen dem Deckel (1) und dem Außenkontakt (3) angeordnet ist,
**dadurch gekennzeichnet, dass**
auf der Innenseite des Deckels (1) ein Mittelteil (5) angeordnet ist, das eine Kontaktbrücke (6) aufweist, die mit einem vom Aktor Kommenden Aktorkontakt (8) elektrisch kontaktierbar ist und die mit dem Außenkontakt (3) elektrisch kontaktiert ist.

2. Abdeckung nach Anspruch 1,
**dadurch gekennzeichnet,**
**dass** der Deckel (1) mindestens teilweise aus Metall oder Keramik besteht.

3. Abdeckung nach Anspruch 1 oder 2,
**dadurch gekennzeichnet,**
**dass** die Dichtung (2) eine Glasdichtung (2) aufweist, die den durchgeführten Außenkontakt (3) zumindest teilweise umschließt, so dass die Durchführung abgedichtet ist.

4. Abdeckung nach einem der vorangehenden Ansprüche,
**dadurch gekennzeichnet,**
**dass** der Temperatur-Ausdehnungskoeffizient des Außenkontakts (3) und/oder der Glasdichtung (2) kleiner ist als der des Deckels (1) .

5. Abdeckung nach einem der vorangehenden Ansprüche,
**gekennzeichnet durch**
eine an dem Aktorgehäuse (12) befestigbare Kopfplatte (4) mit einer Kopfplatten-Durchführung **durch** die Kopfplatte (4) für den Aktorkontakt (8), wobei der Deckel (1) mit der Kopfplatte (4) verbunden ist.

6. Abdeckung nach Anspruch 5,
**dadurch gekennzeichnet,**
**dass** die Kopfplatte (4) mindestens teilweise aus Metall oder Keramik besteht.

7. Abdeckung nach Anspruch 5 oder 6,
**dadurch gekennzeichnet,**
**dass** der Deckel (1) durch eine Schweißverbindung mit der Kopfplatte (4) verbunden ist.

8. Abdeckung nach einem der Ansprüche 5 bis 7,
**dadurch gekennzeichnet,**
**dass** der Aktor eine Rohrfeder (10) zur Aufbringung einer Vorspannung aufweist, wobei die Kopfplatte (4) durch eine Schweißverbindung mit der Rohrfeder (10) verbindbar ist.

9. Abdeckung nach Anspruch 1,
**dadurch gekennzeichnet,**
**dass** die Kontaktbrücke (6) eine Steckverbindung (7) aufweist, mit welcher der Außenkontakt (3) steckbar elektrisch kontaktiert ist.

10. Abdeckung nach Anspruch 1 oder 9, **dadurch**
**gekennzeichnet, dass**
mehrere Außenkontakte (3) in dem Deckel (1) angeordnet sind, so dass mehrere Aktorkontakte (8) **durch** die Kontaktbrücke (6) mit mehreren Außenkontakten (3) elektrisch kontaktierbar sind.

11. Abdeckung nach einem der Ansprüche 1 bis 10,
**dadurch gekennzeichnet,**
**dass** innerhalb des Deckels (1) ein elektrisches Bauelement (13) angeordnet ist, das mit mindestens einem der Aktorkontakte (8) elektrisch kontaktierbar ist.

12. Abdeckung nach einem der Ansprüche 1 bis 11,
**dadurch gekennzeichnet,**
**dass** das Mittelteil (5) teilweise aus einem elektrisch isolierenden Material besteht, wobei die Kontaktbrücke (6) und/oder das elektrische Bauelement (13) zumindest teilweise in das elektrisch isolierende Material eingebettet sind.

13. Abdeckung nach Anspruch 12,
**dadurch gekennzeichnet,**
**dass** das Mittelteil (5) eine hervorstehende Hülse (9) aus dem elektrisch isolierenden Material aufweist, wobei die Hülse (9) in die Kopfplatten-Durchführung hineingreift und der Aktorkontakt (8) in der Hülse (9) durch die Kopfplatte (4) hindurchgeführt ist, so dass die Hülse (9) eine elektrische Isolierung zwischen dem Aktorkontakt (8) und der Kopfplatte (4) darstellt.

14. Aktor mit einer Abdeckung nach einem der Ansprüche 1 bis 13.

15. Injektor für eine Brennkraftmaschine mit einem Aktor nach Anspruch 14.

16. Einspritzanlage für eine Brennkraftmaschine mit einem Injektor nach Anspruch 15.

17. Herstellungsverfahren für eine Abdeckung für ein Aktorgehäuse (12) eines Aktors, insbesondere eines Piezoaktors, mit den folgenden Schritten:
a) Herstellen eines Deckels (1), welcher als vorgeformtes Formteil (1) hergestellt wird,
b) Anordnen einer Durchführung in dem Deckel (1),
c) Hindurchführen eines Außenkontakts (3), der eine elektrische Ansteuerung des Aktors durch eine externe Steuereinrichtung ermöglicht, durch die Durchführung des Deckels (1) und
d) Anordnen einer Dichtung (2) zwischen dem Deckel (1) und dem Außenkontakt (3), so dass die Durchführung abgedichtet ist, und
e) Anordnen eines Mittelteils (5) auf der Innenseite des Deckels (1), das eine Kontaktbrücke (6) aufweist, und Kontaktieren eines vom Aktor Kommenden Aktorkontakts (8) mit dem Außenkontakt (3) über die Kontaktbrücke (6).

18. Herstellungsverfahren nach Anspruch 17,
**dadurch gekennzeichnet,**
**dass** der Deckel (1) zumindest teilweise aus Metall oder Keramik hergestellt wird.

19. Herstellungsverfahren nach Anspruch 17 oder 18,
**dadurch gekennzeichnet,**
**dass** als Dichtung (2) eine Glasdichtung (2) angeordnet wird, die den hindurchgeführten Außenkontakt (3) zumindest teilweise umschließt, so dass die Durchführung abgedichtet ist.

20. Herstellungsverfahren nach einem der Ansprüche 17 bis 19,
**dadurch gekennzeichnet,**
**dass** der Temperatur-Ausdehnungskoeffizient des Außenkontakts (3) und/oder der Glasdichtung (2) kleiner ist als der des Deckels (1).

21. Herstellungsverfahren nach einem der Ansprüche 18 bis 20,
**gekennzeichnet durch**
die folgenden Schritte:
- Herstellen einer Kopfplatte (4), die an dem Aktorgehäuse (12) befestigbar ist,
- Anordnen zweier Kopfplatten-Durchführungen für jeweils einen Aktorkontakt (8) und
- Verbinden des Deckels (1) mit der Kopfplatte (4).

22. Herstellungsverfahren nach Anspruch 21,
**dadurch gekennzeichnet,**
**dass** die Kopfplatte (4) mindestens teilweise aus Metall oder Keramik hergestellt wird.

23. Herstellungsverfahren nach Anspruch 21 oder 22,
**dadurch gekennzeichnet,**
**dass** der Aktor eine Rohrfeder (10) zur Aufbringung einer Vorspannung aufweist, wobei die Kopfplatte (4) mit der Rohrfeder (10) verschweißt wird.

24. Herstellungsverfahren nach Anspruch 17,
**dadurch gekennzeichnet,**
**dass** die Kontaktbrücke (6) mit einer Steckverbindung (7) ausgerüstet wird, mit welcher der Außenkontakt (3) steckbar elektrisch kontaktiert wird.

25. Herstellungsverfahren Anspruche 17 oder 24,
**dadurch gekennzeichnet,**
**dass** innerhalb des Deckels (1) ein elektrisches Bauelement (13) angeordnet wird, das mit mindestens einem Aktorkontakt (8) elektrisch kontaktiert wird.

26. Herstellungsverfahren nach einem der Ansprüche 17 bis 25,
**dadurch gekennzeichnet,**
**dass** das Mittelteil (5) teilweise aus einem elektrisch isolierenden Material hergestellt wird und die Kontaktbrücke (6) und/oder das elektrische Bauelement (13) zumindest teilweise in das elektrisch isolierendes Material eingebettet wird.

27. Herstellungsverfahren nach einem der Ansprüche 17 bis 26,
**gekennzeichnet durch**
die folgenden Schritte:
- Bohren der Durchführungen in den Deckel (1), wobei der Deckel (1) aus Metall besteht,
- Erwärmen des Deckels (1),
- Einsetzen der erwärmten Glasdichtung (2) in den Deckel (1),
- Einsetzen des Außenkontakts (3) in den Deckel (1),
- Abkühlen des Deckels (1) mit der Glasdichtung (2) und dem Außenkontakt (3), so dass der Außenkontakt (3) und die Glasdichtung (2) verspannt in dem Deckel (1) verbleiben,
- Aufsetzen des Deckels (1) auf die Kopfplatte (4), wobei der Außenkontakt (3) in die Steckverbindung (7) gesteckt wird und
- Anschweißen des Deckels (1) an der Kopfplatte (4).

## Claims

1. Cover for an actuator housing (12) of an actuator, especially a piezo-actuator, having
a lid (1) which seals the exterior of the actuator housing (12), the lid (1) being a pre-shaped moulded part (1),
a bushing arranged in the lid (1),
an external contact (3) passed through the bushing, which permits electrical control of the actuator by an external control unit, and
a seal (2) to seal the bushing, which is arranged between
the lid (1) and the external contact (3),
**characterised in that**
on the interior of the lid (1) is arranged a centre part (5) which has a contact bridge (6) which can be electrically contacted with an actuator contact (8) coming from the actuator and which is electrically contacted with the external contact (3).

2. Cover according to claim 1,
**characterised in that**
the lid (1) consists at least in part of metal or ceramic.

3. Cover according to claim 1 or 2,
**characterised in that**
the seal (2) has a glass seal (2) which at least partially encloses the passed-through external contact (3), so that the bushing is sealed.

4. Cover according to one of the preceding claims,
**characterised in that**
the temperature expansion coefficient of the external contact (3) and/or of the glass seal (2) is smaller than that of the lid (1) .

5. Cover according to one of the preceding claims,
**characterised by**
a cover plate (4) that can be fixed to the actuator housing (12) and which has a cover plate bushing through the cover plate (4) for the actuator contact (8), the lid (1) being connected to the cover plate (4).

6. Cover according to claim 5,
**characterised in that**
the cover plate (4) consists at least in part of metal or ceramic.

7. Cover according to claim 5 or 6,
**characterised in that**
the lid (1) is connected to the cover plate (4) by a welded connection.

8. Cover according to one of claims 5 to 7,
**characterised in that**
the actuator has a tubular spring (1) to apply pre-tension, it being possible to connect the cover plate (4) to the tubular spring (10) by a welded connection.

9. Cover according to claim 1,
**characterised in that**
the contact bridge (6) has a plug-in connection (7) with which the external contact (3) can be electrically contacted by plugging in.

10. Cover according to claim 1 or 9,
**characterised in that**
a plurality of external contacts (3) is arranged in the lid (1), so that a plurality of actuator contacts (8) can be electrically contacted to a plurality of external contacts (3) through the contact bridge (6).

11. Cover according to one of claims 1 to 10,
**characterised in that**
an electrical component (13) is arranged within the lid (1) and can be electrically contacted to at least one of the actuator contacts (8).

12. Cover according to one of claims 1 to 11,
**characterised in that**
the centre part (5) consists in part of an electrically insulating material, the contact bridge (6) and/or the electrical component (13) being at least in part embedded into the electrically insulating material.

13. Cover according to claim 12,
**characterised in that**
the centre part (5) has a projecting sleeve (9) made of the electrically insulating material, the sleeve (9) engaging into the cover plate bushing and the actuator contact (8) being passed through the cover plate (4) in the sleeve (9) so that the sleeve (9) represents an electrical insulation between the actuator contact (8) and the cover plate (4).

14. Actuator with a cover according to one of claims 1 to 13.

15. Injector for an internal combustion engine with an actuator according to claim 14.

16. Injection system for an internal combustion engine with an injector according to claim 15.

17. Manufacturing method for a cover for an actuator housing (12) of an actuator, especially a piezo-actuator, having the following steps:
a) manufacturing a lid (1) which is manufactured as a pre-shaped moulded part (1),
b) arranging a bushing in the lid (1),
c) passing an external contact (3), which permits electrical control of the actuator by means of an external control unit, through the bushing of the cover (1) and
d) arranging a seal (2) between the lid (1) and the external contact (3) so that the bushing is sealed, and
e) arranging a centre part (5) on the interior of the lid (1) which has a contact bridge (6), and contacting an actuator contact (8) coming from the actuator to the external contact (3) via the contact bridge (6).

18. Manufacturing method according to claim 17,
**characterised in that**
the lid (1) is manufactured at least in part of metal or ceramic.

19. Manufacturing method according to claim 17 or 18,
**characterised in that**
a glass seal (2) is arranged as a seal (2) and encloses at least partially the passed-through external contact (3), so that the bushing is sealed.

20. Manufacturing method according to one of claims 17 to 19,
**characterised in that**
the temperature expansion coefficient of the external contact (3) and/or of the glass seal (2) is smaller than that of the lid (1) .

21. Manufacturing method according to one of claims 18 to 20,
**characterised by**
the following steps:
- manufacturing a cover plate (4) that can be fixed to the actuator housing (12),
- arranging two cover plate bushings for an actuator contact (8) in each case and
- connecting the lid (1) to the cover plate (4).

22. Manufacturing method according to claim 21,
**characterised in that**
the cover plate (4) is manufactured at least in part of metal or ceramic.

23. Manufacturing method according to claim 21 or 22,
**characterised in that**
the actuator has a tubular spring (10) to apply pre-tension, the cover plate (4) being welded to the tubular spring (10).

24. Manufacturing method according to claim 17,
**characterised in that**
the contact bridge (6) is equipped with a plug-in connection (7) with which the external contact (3) can be electrically contacted by plugging in.

25. Manufacturing method according to claims 17 or 24,
**characterised in that**
an electrical component (13) is arranged within the lid (1) and can be electrically contacted to at least one actuator contact (8).

26. Manufacturing method according to one of claims 17 to 25,
**characterised in that**
the centre part (5) is manufactured in part of an electrically insulating material, and the contact bridge (6) and/or the electrical component (13) are at least in part embedded into the electrically insulating material.

27. Manufacturing method according to one of claims 17 to 26,
**characterised by**
the following steps:
- drilling the bushings into the lid (1), the lid (1) consisting of metal,
- heating the cover (1),
- inserting the heated glass seal (2) into the lid (1),
- inserting the external contact (3) into the lid (1),
- cooling the lid (1) with the glass seal (2) and the external contact (3), so that the external contact (3) and the glass seal (2) remain tensioned in the lid (1),
- setting the lid (1) onto the cover plate (4), the external contact (3) being plugged into the plug-in connection and
- welding the lid (1) to the cover plate (4).

## Revendications

1. Capot pour un boîtier d'actionner (12) d'un actionneur, en particulier d'un actionneur piézoélectrique, avec
un couvercle (1) qui étanchéifie le boîtier d'actionneur (12) au niveau de sa face extérieure, le couvercle (1) étant une pièce moulée préformée (1),
une traversée ménagée dans le couvercle (1),
un contact extérieur (3) passé à travers la traversée, qui permet une commande électrique de l'actionneur par une unité de commande externe, et
un joint (2) pour étanchéifier la traversée, qui est monté entre le couvercle (1) et le contact extérieur (3), **caractérisé en ce que**
sur la face intérieure du couvercle (1) est montée une pièce centrale (5) qui présente un pont de contact (6) qui peut être mis en contact électrique avec un contact d'actionneur (8) provenant de l'actionneur et qui est mis en contact électrique avec le contact extérieur (3).

2. Capot selon la revendication 1,
**caractérisé en ce que**
le couvercle (1) est constitué au moins en partie de métal ou de céramique.

3. Capot selon la revendication 1 ou 2,
**caractérisé en ce que**
le joint (2) possède un joint en verre (2) qui entoure au moins partiellement le contact extérieur (3) traversant, de sorte que la traversée est étanchéifiée.

4. Capot selon l'une des revendications précédentes,
**caractérisé en ce que**
le coefficient de dilatation thermique du contact extérieur (3) et/ou du joint en verre (2) est inférieur à celui du couvercle (1).

5. Capot selon l'une des revendications précédentes,
**caractérisé par**
une plaque supérieure (4) pouvant être fixée au boîtier d'actionneur (12), avec une traversée de plaque supérieure à travers la plaque supérieure (4) pour le contact d'actionneur (8), le couvercle (1) étant relié avec la plaque supérieure (4).

6. Capot selon la revendication 5,
**caractérisé en ce que**
la plaque supérieure (4) est constituée au moins en partie de métal ou de céramique.

7. Capot selon la revendication 5 ou 6,
**caractérisé en ce que**
le couvercle (1) est relié avec la plaque supérieure (4) par une liaison soudée.

8. Capot selon l'une des revendications 5 à 7,
**caractérisé en ce que**
l'actionneur possède un tube-ressort (10) pour appliquer une tension initiale, la plaque supérieure (4) pouvant être reliée avec le tube-ressort (10) par une liaison soudée.

9. Capot selon la revendication 1,
**caractérisé en ce que**
le pont de contact (6) possède une fiche (7) avec laquelle le contact extérieur (3) peut être mis en contact électrique par enfichage.

10. Capot selon la revendication 1 ou 9,
**caractérisé en ce que**
plusieurs contacts extérieurs (3) sont montés dans le couvercle (1), de sorte que plusieurs contacts d'actionneur (8) peuvent être mis en contact électrique avec plusieurs contacts extérieurs (3) par le pont de contact (6).

11. Capot selon l'une des revendications 1 à 10,
**caractérisé en ce que**
à l'intérieur du couvercle (1) est monté un composant électrique (13) qui peut être mis en contact électrique avec au moins un des contacts d'actionneur (8).

12. Capot selon l'une des revendications 1 à 11,
**caractérisé en ce que**
la pièce centrale (5) est constituée en partie d'un matériau isolant électriquement, le pont de contact (6) et/ou le composant électrique (13) étant au moins partiellement scellés dans le matériau isolant électriquement.

13. Capot selon la revendication 12,
**caractérisé en ce que**
la pièce centrale (5) possède un manchon saillant (9) fait dans le matériau isolant électriquement, ce manchon (9) pénétrant dans la traversée de la plaque supérieure et le contact d'actionneur (8) pénétrant dans le manchon (9) à travers la plaque supérieure (4), de sorte que le manchon (9) réalise une isolation électrique entre le contact d'actionneur (8) et la plaque supérieure (4).

14. Actionneur avec un capot selon l'une des revendications 1 à 13.

15. Injecteur pour un moteur à combustion interne avec un actionneur selon la revendication 14.

16. Système d'injection pour un moteur à combustion interne avec un injecteur selon la revendication 15.

17. Procédé de fabrication d'un capot pour un boîtier d'actionneur (12) d'un actionneur, en particulier d'un actionneur piézoélectrique, comprenant les étapes suivantes :
a) fabrication d'un couvercle (1) qui est fabriqué comme une pièce moulée préformée (1),
b) création d'une traversée dans le couvercle (1),
c) passage d'un contact extérieur (3) qui permet une commande électrique de l'actionneur par un dispositif de commande externe, à travers la traversée du couvercle (1),
d) montage d'un joint (2) entre le couvercle (1) et le contact extérieur (3), de sorte que la traversée est étanchéifiée, et
e) montage sur la face intérieure du couvercle (1) d'une pièce centrale (5) qui possède un pont de contact (6), et mise en contact par le pont de contact (6) d'un contact d'actionneur (8) provenant de l'actionneur avec le contact extérieur (3).

18. Procédé de fabrication selon la revendication 17,
**caractérisé en ce que**
le couvercle (1) est fabriqué au moins en partie en métal ou en céramique.

19. Procédé de fabrication selon la revendication 17 ou 18,
**caractérisé en ce que**
en guise de joint (2) est monté un joint en verre (2) qui entoure au moins en partie le contact extérieur (3) traversant, de sorte que la traversée est étanchéifiée.

20. Procédé de fabrication selon l'une des revendications 17 à 19,
**caractérisé en ce que**
le coefficient de dilatation thermique du contact extérieur (3) et/ou du joint en verre (2) est inférieur à celui du couvercle (1).

21. Procédé de fabrication selon l'une des revendications 18 à 20,
**caractérisé par**
les étapes suivantes :
- fabrication d'une plaque supérieure (4) qui peut être fixée au boîtier d'actionneur (12),
- création de deux traversées de plaque supérieure destinée chacune à un contact d'actionneur (8) et
- liaison du couvercle (1) avec la plaque supérieure (4).

22. Procédé de fabrication selon la revendication 21,
**caractérisé en ce que**
la plaque supérieure (4) est fabriquée au moins en partie en métal ou en céramique.

23. Procédé de fabrication selon la revendication 21 ou 22,
**caractérisé en ce que**
l'actionneur possède un tube-ressort (10) pour appliquer une tension initiale, la plaque supérieure (4) étant soudée avec le tube-ressort (10).

24. Procédé de fabrication selon la revendication 17,
**caractérisé en ce que**
le pont de contact (6) est équipé d'une fiche (7) avec laquelle le contact extérieur (3) peut être mis en contact électrique par enfichage.

25. Procédé de fabrication selon la revendication 17 ou 24,
**caractérisé en ce que**
à l'intérieur du couvercle (1) est monté un composant électrique (13) qui est mis en contact électrique avec au moins un contact d'actionneur (8).

26. Procédé de fabrication selon l'une des revendications 17 à 25,
**caractérisé en ce que**
la pièce centrale (5) est fabriquée en partie dans un matériau isolant électriquement et le pont de contact (6) et/ou le composant électrique (13) sont scellés au moins partiellement dans le matériau isolant électriquement.

27. Procédé de fabrication selon l'une des revendications 17 à 26,
**caractérisé par**
les étapes suivantes :
- perçage des traversées dans le couvercle (1), le couvercle (1) étant en métal,
- chauffage du couvercle (1),
- insertion du joint en verre (2) chauffé dans le couvercle (1),
- insertion du contact extérieur (3) dans le couvercle (1),
- refroidissement du couvercle (1) avec le joint en verre (2) et le contact extérieur (3), de sorte que le contact extérieur (3) et le joint en verre (2) restent en tension dans le couvercle (1),
- pose du couvercle (1) sur la plaque supérieure (4), le contact extérieur (3) étant inséré dans la fiche (7) et
- soudage du couvercle (1) sur la plaque supérieure (4).
